Europäisches Patentamt

European Patent Office

Office européen des brevets

(11) Publication number: **0 194 682**
**B1**

# EUROPEAN PATENT SPECIFICATION

(45) Date of publication of patent specification: **23.01.91**

(51) Int. Cl.⁵: **H 01 L 27/10**

(21) Application number: **86103362.9**

(22) Date of filing: **13.03.86**

(54) Semiconductor memory device.

(30) Priority: **13.03.85 JP 49972/85**
**22.04.85 JP 85989/85**

(43) Date of publication of application:
**17.09.86 Bulletin 86/38**

(45) Publication of the grant of the patent:
**23.01.91 Bulletin 91/04**

(84) Designated Contracting States:
**DE FR GB**

(56) References cited:
**EP-A-0 098 165**
**DE-A-2 728 928**

**PATENTS ABSTRACTS OF JAPAN, vol. 8, no.
221 (E-271)1658r, 9th October 1984; & JP - A - 59
104 156 (TOSHIBA K.K.) 15-06-1984**

**PATENTS ABSTRACTS OF JAPAN, vol. 5, no.
121 (E-68)793r, 5th August 1981; & JP - A - 56 58
255 (OKI DENKI KOGYO K.K.) 21-05-1981**

(73) Proprietor: **KABUSHIKI KAISHA TOSHIBA
72, Horikawa-cho Saiwai-ku
Kawasaki-shi Kanagawa-ken 210 (JP)**

(72) Inventor: **Maeda, Satoshi 102, Hillside Heights
5-2-12, Baba Tsurumi-ku
Yokohama-shi Kanagawa-ken (JP)**

(74) Representative: **Lehn, Werner, Dipl.-Ing. et al
Hoffmann, Eitle & Partner Patentanwälte
Arabellastrasse 4
D-8000 München 81 (DE)**

(56) References cited:
**PATENTS ABSTRACTS OF JAPAN, vol. 4, no.
133 (E-26)615r, 18th September 1980; & JP - A -
55 85 054 (HITACHI SEISAKUSHO K.K.) 26-06-
1980**

**IEEE ELECTRON DEVICE LETTERS, vol. EDL-4,
no. 4, April 1983, pages 90,91, IEEE, New York,
US; H. SUNAMI et al.: "A corrugated capacitor
cell (CCC) for megabit dynamic MOS memories"**

## Description

The present invention relates to a semiconductor memory device, preferably for use as a dynamic RAM (dRAM).

From Patents Abstracts of Japan, Vol. 8, No. 221 (E-271) (1658) of Oct. 9, 1984, and JP—A—59 104 156 it is known a semiconductor device comprising a semiconductor substrate of a first conductivity type; an insulating film for isolation between cells provided on the surface of said semiconductor substrate; a first electrode layer provided on the surface of said substrate partioned by said isolation insulating film through a first insulating film; a hole penetrating through said first electrode layer and said first insulating film; and a second electrode layer provided at least on said first electrode layer and within said hole through a second insulating film, a portion of said second electrode layer being connected to said substrate through said hole.

Patents Abstracts of Japan, Vol. 5, No. 121 (E-68) (793) of Aug. 5, 1981, and JP—A—56 58 255 disclose a semiconductor memory device of a similar structure which further comprises a first diffusion region of a second conductivity type provided in an area near said surface of said semiconductor substrate to which an electrode is connected, and a second diffusion region of a second conductivity type provided in an area near said surface of said semiconductor substrate, and a transfer gate electrode provided below said first electrode layer as well as a transfer gate electrode provided on said second electrode layer.

IEEE Electron Device Letters, Vol. EDL 4, No. 4 of April 1983, pages 90, 91, IEEE, New York, US, include a publication of H. Sunami et al. "A corrugated capacitor cell (CCC) for megabit dynamic MOS memories" disclosing to a provide in a DRAM a groove containing a capacitor electrode.

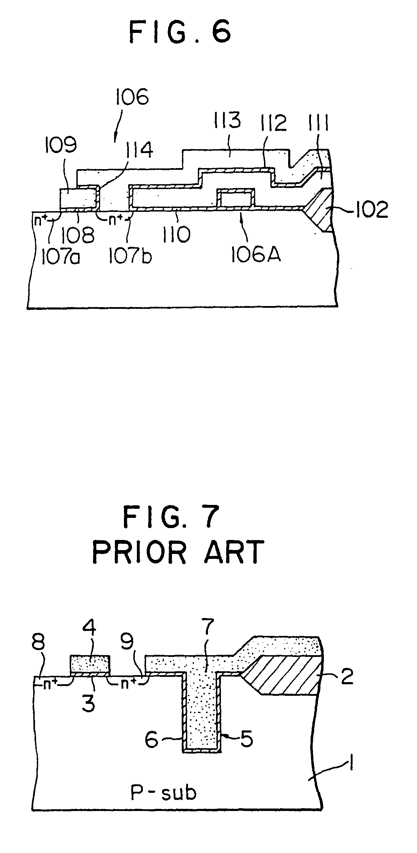

An example of a semiconductor device as known from prior art and including a groove for increasing the capacity of a capacitor is illustrated in Fig. 7 of the enclosed drawings. In that example, on the surface of a substrate 1 of a p-type silicon, an insulating film 2 for isolation between cells is provided. On the surface of the substrate 1 region (memory cell region) partitioned by the isolation insulating film 2, a transfer gate electrode 4 of e.g. a polycrystalline silicon through a gate oxide film 3. Further, a groove 5 is opened in a portion of the substrate 1 within the memory cell region. On the surface of the substrate 1 including the inner surface of the groove 5, a capacitor oxide film 6 is formed. In addition, on the capacitor oxide film 6, a capacitor electrode 7 of e.g. a polycrystalline silicon is provided. This capacitor electrode 7 extends on the insulating film 2 for isolation between cells. It is disposed over a plurality of memory cell regions. Further, on the surface of the substrate 1 at the both sides of the transfer gate electrode 4, $n^+$ type diffusion regions 8 and 9 serving as a source and a drain are provided. Since such a dRAM can form the capacitor on the inner surface of the groove 5, it is possible to effectively increase the capacity of a capacitor without increasing the area of capacitor.

Meanwhile, in order to further improve the integration of the dRAM and to maintain the capacity of the capacitor above a predetermined value to prevent soft error, it is required to deepen the depth of the groove when the structure shown in Fig. 7 is employed. For instance, when the opening portion of the groove is formed by a square pattern of l μm by l μm and the depth thereof is h μm, the area of the inner peripheral surface is expressed as $(4lh+l^2)$. In this instance, when hyper-fining with the capacity per each groove is at the predetermined value, it is required to deepen the depth h. However, when an attempt is made to deepen the depth of the groove, there occurs the problem in respect of rinse of internal surface of the groove, resulting in the difficulty from a viewpoint of mass-production.

On the other hand, a scheme can be used to thin the film thickness of the capacitor oxide film, thereby maintaining the capacity of the capacitor above a predetermined value. However, the capacitor oxide film is in itself from a viewpoint of preventing degradation of a leak characteristic e.g. a tunnel current etc. due to field concentration at an edge of the groove. Accordingly, it is unable to thin the film thickness of the capacitor oxide film to much extent.

An object of the present invention is to provide a semiconductor memory device which can be easily mass-produced, which has high tolerance with respect to soft error, and which can be highly integrated.

Another object of the present invention is to provide a semiconductor memory device which can maintain a predetermined capacity of a capacitor even when the integration is improved.

According to the present invention, these and other objects are solved by a semiconductor memory device comprising the features of claim 1 hereof.

Specific improvements according to the present invention may be seen from the subclaims hereof.

The groove-type capacitor in the claimed semiconductor memory device is actually defined by two capacitances. The first capacitance is defined by a first insulating film formed on the surface of the substrate, a portion of the substrate, and a first electrode layer formed on said first insulating film. The second capacitance is defined by a second insulating film formed on said first electrode layer, a portion of said first electrode layer, and a second electrode layer formed on said second insulating film. The structure according to the present invention provides a large cell capacitance in comparison to the size of its surface area.

In the enclosed drawings, several embodiments of semiconductor memory devices are illustrated as follows.

Fig. 1 shows a cross sectional view of an embodiment of a semiconductor memory device;

Fig. 2 shows a cross sectional view of another embodiment of a semiconductor memory device;

Fig. 3 shows a cross sectional view of preferred embodiment of a semiconductor memory device according to the invention;

Fig. 4 shows a cross sectional view of another embodiment of a semiconductor memory device;

Fig. 5 shows a cross sectional view illustrating providing of a groove type capacitor in the embodiment shown in Fig. 3;

Fig. 6 shows a cross sectional view illustrating providing of a transfer gate electrode in the embodiment shown in Fig. 3; and

Fig. 7 shows a cross sectional view illustrating a groove type memory cell of a conventional dRAM.

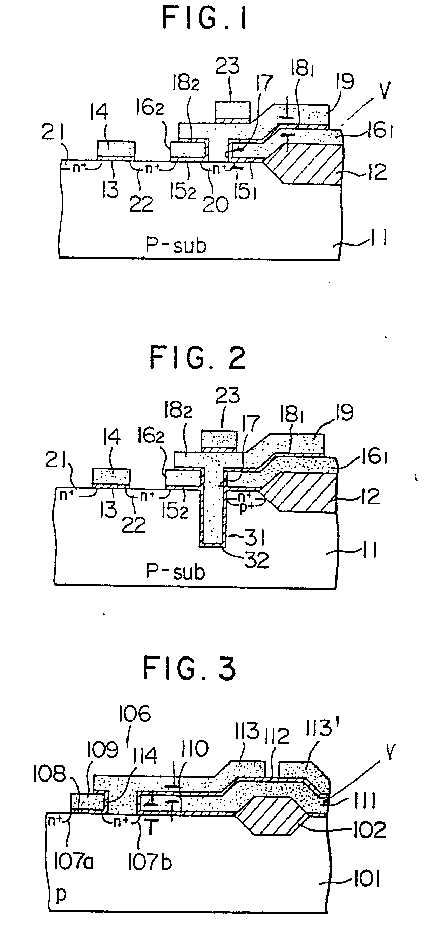

Initially, referring to Fig. 1, on the surface of a substrate of e.g. p-type silicon, an insulating film 12 for isolation between cells is provided. On a portion of the substrate 11 region (memory cell region) partitioned by the isolation insulating film 12, a transfer gate electrode 14 of e.g. polycrystalline silicon is provided through a gate oxide film 13. On the surface of the substrate 11 of the memory cell region, first electrode layers $16_1$ and $16_2$ of e.g. polycrystalline silicon are provided through thermal oxide films $15_1$ and $15_2$ as a first insulating film. The first electrode layers $16_1$ and $16_2$ is disposed in a manner the one side is spaced from the transfer gate 14 by a predetermined distance and the other side extends on the isolation insulating film 12. A hole 17 is opened, penetrating through the first electrode layers $16_1$ and $16_2$ and the thermal oxide films $15_1$ and $15_2$. On the most part of the surface of the first electrode layers $16_1$ and $16_2$ and within the hole 17, a second electrode 19 of e.g. polycrystalline silicon is provided through e.g. thermal oxide films $18_1$ and $18_2$ as a second insulating film. This electrode 19 is connected to an $n^+$ type diffusion region 20 formed on the surface of the substrate 11 through the hole 17. A voltage is not applied to the second electrode 19 and it is placed in a floating condition. Further, on the surface at the both sides of the transfer gate electrode 14, $n^+$ type diffusion regions 20 and 22 serving as a source and a drain are provided. A transfer gate electrode 23 is provided on the second electrode layer 19 through a $SiO_2$ film.

In accordance with the configuration stated above, by applying a predetermined voltage to the first electrode layers $16_1$ and $16_2$, the capacity of a capacitor in respect of one memory cell is given by the sum of the capacity of the thermal oxide films $15_1$ and $15_2$ between the first electrode layers $16_1$ and $16_2$ and the substrate and the capacity of the thermal oxide films $18_1$ and $18_2$ between the first electrode layers $16_1$ and $16_2$ and the second electrode layer 19. As a result, this structure can increase the capacity of a capacitor three to five times larger than that of the conventional planar capacitor. Accordingly, this makes it possible to extremely lessen the influence of minority carrier in the substrate produced by α-ray etc., thus improving tolerance with respect to soft error.

Further, since a groove is not formed in the substrate in the above-mentioned embodiment, the problem in regard of rinse of the interior of the groove or the like can be eliminated, thus facilitating mass-production.

In the above-mentioned embodiment, the thermal oxide film is used as the second insulating film. However, the second insulating film is not limited to the thermal oxide film. For instance, a silicon nitride film, a composite film of the silicon oxide film and the silicon nitride film, a high melting point metal film or a $SiO_2$ film of high melting point metal may be used.

In the above-mentioned embodiment, a diffusion region of a conductivity type opposite to the substrate may be formed on the surface of the substrate below the first electrode layer. By the provision of the diffusion region below the first electrode layer, when a voltage is applied to the electrode, a depletion layer is spreaded on the surface of the substrate near the first insulating film, thereby making it possible to prevent the capacity of a capacitor from being lowered.

Fig. 2 shows another embodiment. This embodiment provides a semiconductor device additionally provided with a groove type capacitor by adding a groove 31 and a capacitor oxide film 32 respectively corresponding to the groove 5 and the capacitor oxide film 6 to the embodiment shown in Fig. 7.

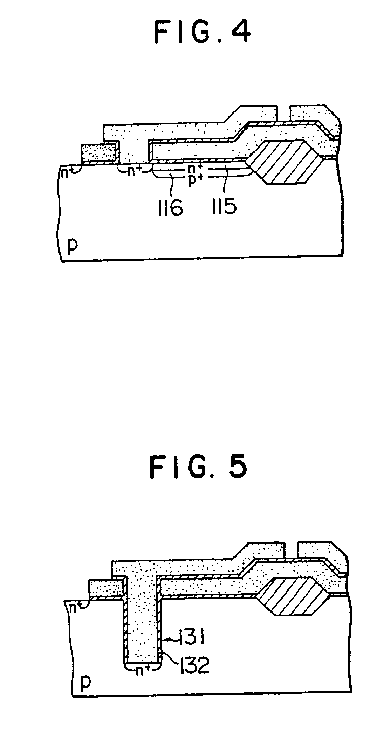

Fig. 3 is a cross sectional view illustrating an embodiment of a memory semiconductor device illustrating in combination with Fig. 5 a preferred embodiment according to the present invention. On a p-type semiconductor substrate 101, an insulating film 102 for isolation between cells is formed similarly to the conventional device. On the surface of the semiconductor substrate 101, a first insulating film 110 (e.g. an oxide film) is formed. On the first insulating film 110, a first electrode layer 111 is formed. The first electrode layer 111 extends over the isolation insulating film 102 to serve as an electrode common to a large number of memory cells. On the first electrode layer 111, a second insulating film 112 (e.g. an oxide film) is further formed. On the second insulating film 112, a second electrode layer 113 is still further formed. According to the configuration of each memory cells, the structure of the second electrode layer 113 is different in general. As shown in Fig. 3, the second electrode layer 113 and the second electrode layer 113' belonging to the adjacent memory cell are electrically connected to each other. The first insulating film 110, a portion of the semiconductor substrate 101 below the first insulating film 110 and the first electrode layer 111 defines a first capacitor. The second insulating film 112, a portion of the first electrode layer 111 below the second insulating film 112 and the second electrode layer 113

defines a second capacitor. These two capacitors are used together as the cell capacitor of the memory.

On the semiconductor substrate 101, a transfer transistor 106 for transferring charge to the above-mentioned cell capacitor is provided. This transfer transistor 106 is the same as the conventional device shown in Fig. 7. Accordingly, parts identical to those in Fig. 7 are designated by the same reference numerals, respectively, and their explanation will be omitted. Both electrodes 107a and 107b of the transfer transistor 106 each comprises an $n^-$ diffusion layer buried into the semiconductor substrate 101. One electrode 107b is connected to the semiconductor substrate 101 and also connected to the second electrode layer 113. Between the transfer gate electrode 109 and the second electrode layer 113, an isolation insulating film 114 is formed.

Because a predetermined voltage is always applied to the first electrode layer 111, by controlling a voltage applied to the transfer gate electrode 109, it is possible to charge or discharge the cell capacitor. Namely, a charge supplied to the cell capacitor via the transfer transistor 106 is accumulated in a region near the first insulating film 110 within the semiconductor substrate 101 and in a region near the second insulating film 112 within the second electrode layer 113. Thus, the semiconductor device of this embodiment can maintain the capacity of a capacitor substantially twice larger than that in the conventional device without digging a groove in the semiconductor substrate. It is needless to say that it is possible to further increase the capacity of the capacitor by digging a groove in the semiconductor substrate.

Fig. 4 is a cross sectional view illustrating a further embodiment. Parts identical to those of the embodiment shown in Fig. 3 are designated by the same reference numerals, respectively, and their explanation will be omitted. This embodiment is characterized in that an $n^+$ diffusion layer 115 is provided below the first insulating film 110 and a $p^-$ diffusion layer 116 is provided below the $n^+$ diffusion layer 115. Thus, a pn junction is formed by these two diffusion layers 115 and 116, with the result that a capacity of the pn junction can be obtained, thus further increasing the capacity of a capacitor.

Fig. 5 in combination with Fig. 3 shows the preferred embodiment of the present invention. This embodiment provides a semiconductor device additionally provided with a groove type capacitor by adding a groove 131 and a capacitor oxide film 132 respectively corresponding to the groove 5 and the capacitor oxide film in Fig. 7 to the embodiment shown in Fig. 3.

Fig. 6 shows a further embodiment wherein a transfer gate electrode 106A is added to the embodiment shown in Fig. 3.

## Claims

1. A semiconductor memory device having a memory cell, which is partitioned by an insulating film (102) for isolation between cells on the surface of a semiconductor substrate (101), comprising:

(a) a semiconductor substrate (101) having a top surface;

(b) a first insulating film (110) formed on the semiconductor substrate (101);

(c) a first electrode layer (111) formed on the first insulating film (110), a predetermined voltage being applied to the first electrode layer;

(d) a hole penetrating through the first electrode layer (111) and the first insulating film (110);

(e) a second insulating film (112) formed on the first electrode layer (111), extending through the hole and contacting the first insulating film (110) at a position at the top surface of the substrate (101);

(f) a second electrode layer (113) formed on the second insulating film (112);

(g) a groove (131) formed in the substrate (101) below the hole, the groove (131) having side walls and a bottom wall, a third insulating film (132) contacting the first and second insulating films (110, 112) at the position at the top surface of the substrate (101) and extending into the groove (131) to cover the side walls of the groove (131), at least a portion of the second electrode layer (113) extending through the hole and into the groove (131) and making contact with the substrate (101) through the groove (131); and

(h) a transfer transistor (106) for transferring charge to the semiconductor substrate (101) and the second electrode layer (113), one electrode of the transfer transistor (106) being provided on the bottom wall of the groove (131);

whereby the first insulating film (110), a portion of the semiconductor substrate (101) below the first insulating film (110) and the first electrode layer (111) define a first capacitor, and the second insulating film (112), a portion of the first electrode layer (111) below the second insulating film (112) and the second electrode layer (113) define a second capacitor, thus using the first and second capacitors as the cell capacitor of the memory.

2. A semiconductor memory device as set forth in claim 1, wherein the transfer transistor (106) is comprised of a field-effect transistor formed on the semiconductor substrate (101), one electrode of the transistor being buried into the semiconductor substrate (101) and connected thereto, the second electrode layer (113) being connected to the electrode of the transistor.

3. A semiconductor memory device as set forth in claim 2, wherein the electrode of the transistor (106) buried into the semiconductor substrate (101) comprises a doped layer of a conductivity type opposite to the semiconductor substrate (101).

4. A semiconductor memory device as set forth in claim 1, wherein the semiconductor substrate (101) comprises a doped layer of a conductivity type opposite to the semiconductor substrate (101), and a heavily doped layer of the same conductivity type as the semiconductor substrate (101) is provided below the doped layer provided below the first insulating film (110).

5. A semiconductor memory device as set forth in claim 2, wherein the semiconductor substrate (101) comprises a doped layer of a conductivity type opposite to the semiconductor substrate (101), and a heavily doped layer of the same conductivity type as the semiconductor substrate is provided below the doped layer provided below the first insulating film (110).

6. A semiconductor memory device as set forth in claim 3, wherein the semiconductor substrate (101) comprises a doped layer of a conductivity type opposite to the semiconductor substrate (101), and a heavily doped layer of the same conductivity type as the semiconductor substrate (101) is provided below the doped layer provided below the first insulating film (110).

## Patentansprüche

1. Halbleiterspeichereinrichtung mit einer Speicherzelle, welche durch einen Isolierfilm (102) zur Isolation zwischen Zellen auf der Oberfläche eines Halbleitersubstrats (101) unterteilt ist, enthaltend:

(a) ein Halbleitersubstrat (101) mit einer oberen Fläche;

(b) einen ersten auf dem Halbleitersubstrat (10) gebildeten Isolierfilm (110);

(c) eine erste auf dem ersten isolierenden Film (110) gebildete Elektrodenschicht (111), wobei eine vorbestimmte Spannung an die erste Elektrodenschicht angelegt ist;

(d) eine die erste Elektrodenschicht (111) und den ersten isolierenden Film (110) durchdringende Öffnung;

(e) einen zweiten isolierenden Film (112), der auf der ersten Elektrodenschicht (111) gebildet ist und sich über die Öffnung erstreckt und den ersten isolierenden Film (110) an einer Stelle auf der oberen Fläche des Substrats (101) berührt;

(f) eine zweite Elektrodenschicht (113), die auf dem zweiten isolierenden Film (112) gebildet ist;

(g) einen im Substrat (101) unterhalb der Öffnung gebildeten Graben (131), wobei der Graben (131) Seitenwände und einen boden aufweist, und wobei ein dritter isolierender Film (132) den ersten und zweiten isolierenden Film (110, 112) an der Stelle auf der oberen Fläche des Substrats (101) berührt und sich in den Graben (131) erstreckt, um die Seitenwände des Grabens (131) zu bedecken, und wobei sich zumindest ein Abschnitt der zweiten Elektrodenschicht (113) durch die Öffnung und in den Graben (131) erstreckt und das Substrat (101) durch den Graben (131) berührt; und

(h) einem Übertragungstransistor (106) zum Übertragen von Ladung zum Halbleitersubstrat (101) und zur zweiten Elektrodenschicht (113), wobei eine Elektrode des Übertragungstransistors (106) auf dem Boden des Grabens (131) vorgesehen ist;

wodurch der erste isolierende Film (110), ein Abschnitt des Halbleitersubstrats (101) unterhalb des ersten isolierenden Films (110) und die erste Elektrodenschicht (111) eine erste Kapazität festlegen, und der zweite isolierende Film (112), ein Abschnitt der ersten Elektrodenschicht (111) unterhalb des zweiten isolierenden Films (112) und die zweite Elektrodenschicht (113) eine zweite Kapazität festlegen, wobei die erste und zweite Kapazität als Zellenkapazität des Speichers benutzt werden.

2. Halbleiterspeichereinrichtung nach Anspruch 1, dadurch gekennzeichnet, daß der Übertragungstransistor (106) aus einem Feldeffkettransistor besteht, der auf dem Halbleitersubstrat (101) gebildet ist, wobei eine Elektrode des Transistors in dem Halbleitersubstrat (101) vergraben ist und mit diesem verbunden ist, und die zweite Elektrodenschicht (113) mit der Elektrode des Transistors verbunden ist.

3. Halbleiterspeichereinrichtung nach Anspruch 2, dadurch gekennzeichnet, daß die Elektrode des Transistors (106), die in dem Halbleitersubstrat (101) vergraben ist, eine dotierte Schicht eines zum Halbleitersubstrat (101) entgegengesetzten Leitungstyps aufweist.

4. Halbleiterspeichereinrichtung nach Anspruch 1, dadurch gekennzeichnet, daß das Halbleitersubstrat (101) eine dotierte Schicht eines zum Halbleitersubstrat (101) entgegengesetzten Leitungstyps (101) aufweist, und eine stark dotierte Schicht des gleichen Leitungstyps wie das Halbleitersubstrat (101) unterhalb der dotierten Schicht vorgesehen ist, die unterhalb des ersten isolierenden Films (110) vorgesehen ist.

5. Halbleiterspeichereinrichtung nach Anspruch 2, dadurch gekennzeichnet, daß das Halbleitersubstrat (101) eine dotierte Schicht eines Leitungstyps entgegengesetzt zum Halbleitersubstrat (101) aufweist, und eine stark dotierte Schicht des gleichen Leitungstyps wie das Halbleitersubstrat unterhalb der dotierten Schicht vorgesehen ist, die unterhalb des ersten isolierenden Films (110) vorgesehen ist.

6. Halbleiterspeichereinrichtung nach Anspruch 3, dadurch gekennzeichnet, daß das Halbleitersubstrat (101) eine dotierte Schicht eines Leitungstyps entgegengesetzt zum Halbleitersubstrat (101) aufweist, und eine stark dotierte Schicht des gleichen Leitungstyps wie das Halbleitersubstrat (101) unterhalb der dotierten Schicht vorgesehen ist, die unterhalb des ersten isolierenden Films (110) vorgesehen ist.

## Revendications

1. Un dispositif de mémoire à semi-conducteur comportant une cellule de mémoire, qui est divisée par une pellicule isolante (102) en vue d'une isolation entre des cellules sur la surface d'un substrat semiconducteur (101), comprenant:

(a) un substrat semi-conducteur (101) comportant une surface supérieure;

(b) une première pellicule isolante (110) formée sur le substrat semi-conducteur (101);

(c) une première couche d'électrode (111) formée sur la première pellicule isolante (110), une tension prédéterminée étant appliquée à la première couche d'électrode;

(d) un trou pénétrant à travers la première couche d'électrode (111) et la première pellicule isolante (110);

(e) une deuxième couche isolante (112) formée sur la première couche d'électrode (111), s'étendant à travers le trou et venant en contact avec la première pellicule isolante (110) dans une position située sur la surface supérieure du substrat (101);

(f) une deuxième couche d'électrode (113) formée sur la deuxième pellicule isolante (112);

(g) une rainure (131) formée dans le substrat (101) au-dessous du trou, la rainure (131) comportant des parois latérales et une paroi de fond, une troisième pellicule isolante (132) étant en contact avec la première et la deuxième pellicules isolantes (110, 112) à la position située sur la surface supérieure du substrat (101) et s'étendant dans la rainure (131) pour couvrir les parois latérales de la rainure (131), au moins une partie de la deuxième couche d'électrode (113) s'étendant à travers le trou et dans la rainure (131) et réalisant un contact avec le substrat (101) à travers la rainure (131); et

(h) un transistor de transfert (106) pour transférer une charge au substrat semi-conducteur (101) et à la deuxième couche d'électrode (113), une électrode du transistor de transfert (106) étant disposée sur la paroi de fond de la rainure (131);

grâce à quoi la première pellicule isolante (110), une partie du substrat semi-conducteur (101) au-dessous de la première pellicule isolante (110) et la première couche d'électrode (111) définissent un premier condensateur, et la deuxième pellicule isolante (112), une partie de la première couche d'électrode (111) située au-dessous de la deuxième pellicule isolante (112) et la deuxième couche d'électrode (113) définissent un deuxième condensateur, en utilisant ainsi le premier et le deuxième condensateurs en tant que condensateur de cellule de la mémoire.

2. Un dispositif de mémoire semi-conducteurs selon la revendication 1, dans lequel le transistor de transfert (106) comprend un transistor à effet de champ formé sur le substrat semi-conducteur (101), une électrode du transistor étant noyée dans le substrat semiconducteur (101) et y étant reliée, la deuxième couche d'électrode (113) étant reliée à l'électrode du transistor.

3. Un dispositif de mémoire à semi-conducteurs selon la revendication 2, dans lequel l'électrode du transistor (106) noyée dans le substrat semi-conducteur (101) comprend une couche dopée d'un type de conductivité opposé au substrat semi-conducteur (101).

4. Un dispositif de mémoire à semi-conducteurs selon la revendication 1, dans lequel le substrat semi-conducteur (101) comprend une couche dopée d'un type de conductivité opposé au substrat semi-conducteur (101), et une couche fortement dopée du même type de conductivité que le substrat semi-conducteur (101) est disposée au-dessous de la couche dopée disposée au-dessous de la première pellicule isolante (110).

5. Un dispositif de mémoire à semi-conducteur selon la revendication 2, dans lequel le substrat semi-conducteur (101) comprend une couche dopée d'un type de conductivité opposé au substrat semi-conducteur (101), et une couche fortement dopée du même type de conductivité que le substrat semi-conducteur est disposée au-dessous de la couche dopée disposée au-dessous de la première pellicule isolante (110).

6. Un dispositif de mémoire à semi-conducteur selon la revendication 3, dans lequel le substrat semi-conducteur (101) comprend une couche dopée d'un type de conductivité opposé au substrat semi-conducteur (101), et une couche fortement dopée du même type de conductivité que le substrat semi-conducteur (101) est disposée au-dessous de la couche dopée disposée au-dessous de la première pellicule isolante (110).

# FIG. 1

# FIG. 2

# FIG. 3

1

# FIG. 4

n+   n+   n+
          p+
         116   115

p

# FIG. 5

n+

131
132
n+

p

# FIG. 6

# FIG. 7
# PRIOR ART